# EUROPEAN PATENT SPECIFICATION

(11) **EP 4 075 931 B1**
(45) Date of publication and mention of the grant of the patent: **25.11.2026**
(21) Application number: 20915330.3
(22) Date of filing: 31.12.2020
(51) Int. Cl.: H05K 5/02, H05K 7/20

(54) **ELECTRONIC APPARATUS OUTER COVER AND ELECTRONIC APPARATUS COMPONENT**
AUSSENDECKEL EINES ELEKTRONISCHEN GERÄTS UND ELEKTRONISCHE GERÄTEKOMPONENTE
COUVERCLE EXTÉRIEUR D'APPAREIL ÉLECTRONIQUE ET COMPOSANT D'APPAREIL ÉLECTRONIQUE

(30) Priority: 23.01.2020 CN 202010076923; 12.02.2020 CN 202010089378
(43) Date of publication of application: 19.10.2022
(73) Proprietor: Huawei Technologies Co., Ltd., Shenzhen, Guangdong 518129 (CN)
(72) Inventor: TANG, Yinzhong, Shenzhen, Guangdong 518129 (CN); WANG, Na, Shenzhen, Guangdong 518129 (CN); CHI, Shanjiu, Shenzhen, Guangdong 518129 (CN); WANG, Zhengquan, Shenzhen, Guangdong 518129 (CN)
(74) Representative: Maiwald GmbH
(86) International application number: PCT/CN2020/142419
(87) International publication number: WO 2021/147649

(56) References cited:
- CN-A- 101 965 120
- CN-A- 103 596 391
- CN-A- 105 578 813
- CN-A- 105 578 813
- CN-A- 106 817 864
- CN-A- 108 882 656
- US-A1- 2007 159 791
- US-A1- 2011 235 273
- US-A1- 2014 098 493

## Description

### CROSS-REFERENCE TO RELATED APPLICATIONS

This application claims priority to Chinese Patent Application No. 202010076923.0, filed with the China National Intellectual Property Administration on January 23, 2020 and entitled "COVER AND ELECTRONIC DEVICE". This application claims priority to Chinese Patent Application No. 202010089378.9, filed with the China National Intellectual Property Administration on February 12, 2020 and entitled "ELECTRONIC DEVICE COVER AND ELECTRONIC DEVICE COMPONENT".

### TECHNICAL FIELD

This application relates to the field of information technologies, and in particular, to an electronic device component.

### BACKGROUND

CN105578813A describes a waterproof and dustproof case used for accommodating an electric device. It is described that the case comprises a case housing, top cover plate assemblies, a dustproof assembly, panel assemblies and a waterproof joint. It is described that the top cover plate assemblies are arranged on a top plate of the case housing. It is described that the dustproof assemblies are arranged in openings in left and right sides of a main body plate. It is described that an inner cavity in one side where the dustproof assemblies are arranged is separated into a wind inlet channel and a wind outlet channel via a separator plate. It is described that the panel assemblies are arranged on the front face. It is described that the waterproof joint is arranged on a base plate. It is described that an electric device is embedded in an opening whose profile shape matches that of the electric device, and the opening is arranged in a middle separator plate. It is described that the interior of the case is in a quite closely sealed state, and the waterproof joint and the dustproof assemblies have better waterproof and dustproof effects, so waterproof and dustproof effects of the case are improved. It is described that the interior of the case housing is separated into the wind inlet channel and the wind outlet channel at an air channel, so a circulation heat dissipation air channel is formed and whole heat dissipation performance of the case is improved, thereby improving performance of the electric device and extending service lifetime of the electric device.

With rapid development of information technologies, an electronic device is increasingly and widely used in an edge scenario of a high temperature and relatively poor air quality. To adapt to a relatively harsh environment in the edge scenario, performance of the electronic device such as dust prevention performance, heat dissipation performance, and corrosion resistance, becomes a key factor that affects market competitiveness of the electronic device. In the conventional technology, a dust filter is generally disposed at an air intake vent of a chassis of the electronic device for dust prevention. Although this solution can achieve a relatively good dust prevention effect, cooling wind resistance increases for disposition of the dust filter, affecting heat dissipation performance of the electronic device. In addition, the dust filter is prone to be blocked by dust, and needs to be cleaned and maintained periodically. If maintenance is not performed in time, dust inevitably enters the chassis; and after harmful impurities in the dust are attached to a board, deliquescence occurs in a humidity condition, and the board is corroded. In addition, in a running process of the electronic device, an electronic component such as the board inside the electronic device is prone to be corroded due to impact of a temperature and humidity of an environment. Consequently, performance of the electronic device is affected.

### SUMMARY

This application provides an electronic device cover and an electronic device component, to improve anti-corrosion performance of an electronic device without affecting heat dissipation performance of the electronic device.

The invention and its scope of protection is defined by the appended independent claim. Embodiments of the invention are defined by the appended dependent claims.

### BRIEF DESCRIPTION OF DRAWINGS

FIG. 1 is a schematic diagram of a local structure of an electronic device component according to an embodiment of this application;
FIG. 2 is a schematic diagram of a local structure of an electronic device cover according to an embodiment of this application;
FIG. 3 is a schematic diagram of a flow direction of airflow inside an electronic device cover according to an embodiment of this application;
FIG. 4 is a schematic diagram of a local structure of a first side panel according to an embodiment of this application;
FIG. 5 is a schematic diagram of a local structure of a first side panel according to another embodiment of this application;
FIG. 6 is a schematic diagram of a local structure of a first side panel according to still another embodiment of this application;
FIG. 7 is a schematic diagram of a local structure of a first side panel according to yet another embodiment of this application;
FIG. 8 is a schematic diagram of a local structure of a first side panel according to still yet another embodiment of this application;
FIG. 9 is a schematic diagram of a local structure of a first side panel according to a further embodiment of this application;
FIG. 10 is a schematic diagram of a local structure of a first side panel according to a still further embodiment of this application; and
FIG. 11 is a schematic diagram of a local structure of a first air intake window according to an embodiment of this application.

Reference numerals:
10: Electronic device cover; 20: Electronic device; 21: Chassis; 22: Air intake vent; 23: Air exhaust vent; 11-First air intake window;
12: First air exhaust window; 101: Top panel; 102: Bottom panel; 103: First side panel; 104: Second side panel; 105: Third side panel;
30: Air intake channel; 31: First part; 32: Second part; 40: Air exhaust channel; 41: Third part; 42: Fourth part;
50: Air return channel; 13: Baffle plate; 14: Air guide; 141: Guide vane; 142: First guide trough;
131: Second guide trough; 15: Second air intake window; 16: Second air exhaust window; 17: Third air intake window; 111-third air intake window;
112: First bent portion; 113: Second bent portion; and 114: Air intake vent.

### DESCRIPTION OF EMBODIMENTS

To make the objectives, technical solutions, and advantages of this application clearer, the following further describes this application in detail with reference to the accompanying drawings.

For ease of understanding of an electronic device cover provided in the embodiments of this application, the following first describes an application scenario of the electronic device cover. A camera module provided in the embodiments of this application may be configured to accommodate an electronic device. The electronic device may be a device in the conventional technology, such as a server, a communications device, a network device, a storage device, a router, or a switch. With rapid development of an internet technology and a 5G technology, the electronic device is increasingly and widely used in an edge scenario in a relatively harsh environment. To adapt to conditions such as a high temperature, poor air quality, and a low noise in the edge scenario, features of the electronic device, such as heat dissipation, dust prevention, noise reduction, and corrosion resistance, need to be continuously improved. In the conventional technology, a dust filter is generally disposed at an air intake vent of a chassis of the electronic device for dust prevention. An advantage of this solution is a relatively good dust prevention effect. A disadvantage of this solution is that cooling wind resistance increases due to disposition of the dust filter, which affects heat dissipation performance of the electronic device. In addition, the dust filter is prone to be blocked by dust, and needs to be cleaned and maintained periodically. If maintenance is not performed in time, the dust enters the chassis, and after harmful corrosive impurities in the dust are attached to a board, and deliquescence occurs in a humidity condition, the board is corroded. In a serious case, the board may be short-circuited. In addition, in a running process of the electronic device, an electronic component such as the board inside the electronic device is prone to be corroded due to impact of a temperature and humidity of an environment. Consequently, performance of the electronic device is affected.

Based on this, this application provides an electronic device cover and an electronic device component using the electronic device cover. The electronic device cover can improve anti-corrosion performance of an electronic device without affecting heat dissipation performance of the electronic device.

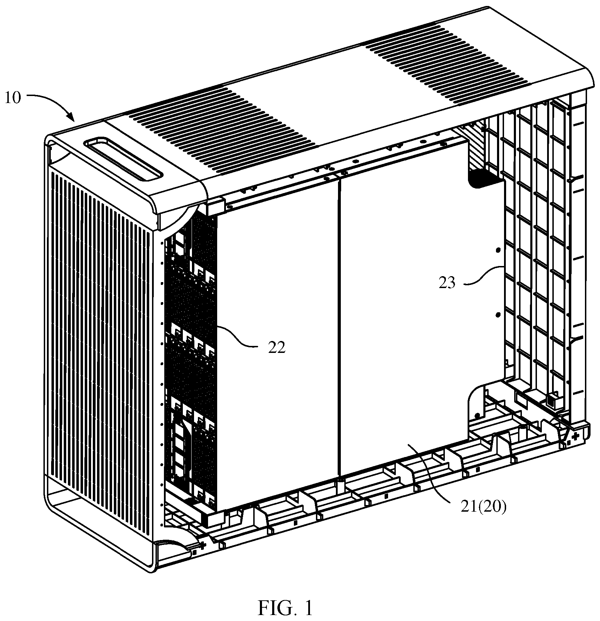

Referring to FIG. 1, an electronic device cover 10 provided in an embodiment of this application may be configured to accommodate an electronic device 20, where according to the claimed invention an electronic device component comprises the electronic device and the electronic device cover The electronic device 20 includes a chassis 21 and components such as a board and a fan disposed inside the chassis 21. An air intake vent 22 and an air exhaust vent 23 are disposed on the chassis 21. During specific disposition, the air intake vent 22 and the air exhaust vent 23 are disposed on two panels on two opposite sides of the chassis 21. An air intake side of the fan is disposed facing the air intake vent 22, and an air exhaust side of the fan is disposed facing the air exhaust vent 23. In this way, cold air outside the chassis 21 enters the chassis 21 from the air intake vent 22 under a suction effect of the fan, and the cold air entering the chassis 21 heats up after exchanging heat with an electronic component. Then, the cold air is discharged out of the chassis 21 through the air exhaust vent 23 under an exhaust effect of the fan, to implement heat dissipation for the electronic device 20.

It should be noted that a relative humidity of air inside the chassis 21 is an important indicator that affects corrosion of the related electronic component. The board is used as an example. Most of cables on the board are made of copper, and a relative humidity threshold for corrosion of the copper in the air is 60%. In an environment in which a relative humidity is above the threshold, a corrosion speed of the copper increases as the relative humidity value increases. In addition, a resistance of the insulation resistance on the board surface decreases as the relative humidity increases. The relative humidity ranging from 60% to 65% is a turning point at which the resistance of the insulation resistance decreases. In addition, when the relative humidity is below 60%, deliquescence does not occur on a highly corrosive substance such as sodium chloride and potassium chloride, and no corrosion effect is caused on the electronic component.

Therefore, a risk of corrosion of the board can be reduced by controlling the relative humidity of the air inside the chassis 21. It may be understood that, when an absolute humidity remains unchanged, a higher temperature indicates a lower relative humidity. According to this principle, an air intake temperature of the chassis 21 may be slightly increased to reduce the relative humidity without affecting normal heat dissipation of the electronic device 20. In this embodiment of this application, the air intake temperature of the chassis 21 is increased by disposing the electronic device cover 10.

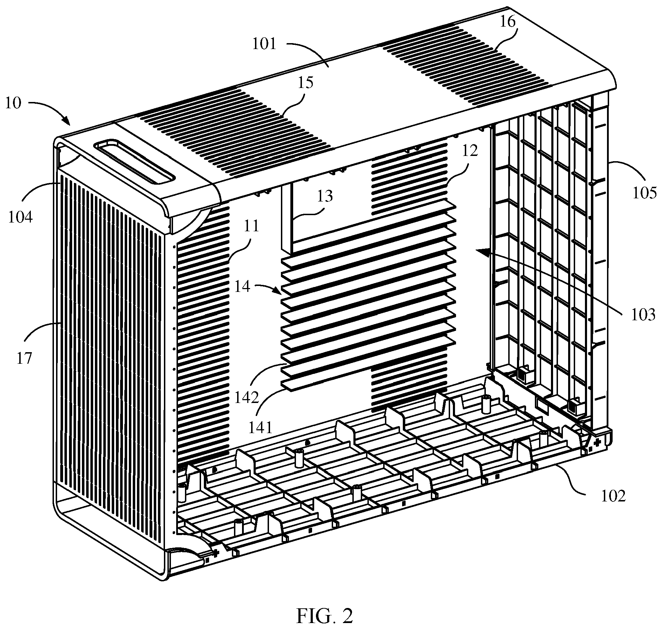

During specific implementation, referring to FIG. 2, that is according to the claimed invention, a first air intake window 11 and a first air exhaust window 12 are disposed on the electronic device cover 10. The first air intake window 11 is configured to communicate with the air intake vent 22 of the chassis 21, form an air intake channel between the first air intake window 11 and the air intake vent 22. The first air exhaust window 12 is configured to communicate with an air exhaust vent 23 of the chassis 21, and form an air exhaust channel between the first air exhaust window 12 and the air exhaust vent 23. When heat is dissipated for the electronic device 20, fresh air outside the electronic device cover 10 may enter the electronic device cover 10 through the first air intake window 11, flow through the air intake channel, and enters the chassis 21 through the air intake vent 22. After heat exchange with the electronic component inside the chassis 21, the fresh air is discharged out of the chassis through the air exhaust channel 23, flows through the air exhaust channel, and may be discharged out of the electronic device cover 10 through the first air exhaust window 12, to complete one heat exchange cycle.

The electronic device cover 10 is further provided with an air return channel. The air return channel communicates with the air exhaust channel and the air intake channel. A part of hot air inside the air exhaust channel may enter the air intake channel through the air return channel, and is mixed with the fresh air entering the air intake channel through the first air intake window 11, to form mixed air whose temperature is slightly higher than that of the fresh air. Under the action of a fan, the mixed air enters the chassis 21 through the air intake channel 22, to increase an air intake temperature of the air intake channel 22. In this way, a cold air area that is inside the chassis 21 and that is close to the air intake vent 22 is eliminated, the relative humidity of the air inside the chassis 21 is reduced, and further, a risk of corrosion of the electronic component such as the board is reduced. In addition, even in an application scenario with relatively poor air quality, for example, in an outdoor environment, because the relative humidity of air inside the chassis is relatively low, deliquescence does not occur on the highly corrosive substance such as sodium chloride and potassium chloride that enters the chassis, and no corrosion effect is caused on the electronic component.

Still referring to FIG. 2, the electronic device cover 10 may be specifically of a hexahedron structure, and, according to the claimed invention, including a top panel 101, a bottom panel 102, a first side panel 103, a second side panel 104, a third side panel 105, and a fourth side panel (not shown in the figure). The top panel 101 and the bottom panel 102 are opposite to each other, the first side panel 103 and the fourth side panel are opposite to each other, and the second side panel 104 and the third side panel 105 are opposite to each other. When the electronic device is disposed inside the electronic device cover 10, the second side panel 104 may be disposed opposite to a panel of a side on which the air intake vent is disposed on the chassis, and the third side panel 105 is disposed opposite to a panel on a side that is on the chassis and on which the air exhaust vent is disposed.

In this embodiment of this application, that is according to the claimed invention, the foregoing first air intake window 11 and the first air exhaust window 12 may be disposed on the first side panel 103. In specific disposition, the first air intake window 11 is located on a side that is on the first side panel 103 and that is close to the second side panel 104, and the first air exhaust window 12 is located on a side that is on the first side panel 103 and that is close to the third side panel 105. It should be understood that the first air intake window 11 and the first air exhaust window 12 may alternatively be disposed on the fourth side panel. In specific disposition, the first air intake window 11 is located on a side that is on the fourth side panel and that is close to the second side panel 104, and the first air exhaust window 12 is located on a side that is on the fourth side panel and that is close to the third side panel 105. To improve a heat dissipation effect on the electronic device, in other embodiments of this application, the first air intake window 11 and the first air exhaust window 12 may be disposed on each of the third side panel 105 and the fourth side panel, thereby increasing air intake paths and air exhaust paths, and improving heat dissipation efficiency.

An example in which the first air intake window 11 and the first air exhaust window 12 are disposed on the first side panel 103 is used in the following to specifically describe a structure of the first side panel 103 and disposition forms of an air intake channel, an air exhaust channel, and an air return channel.

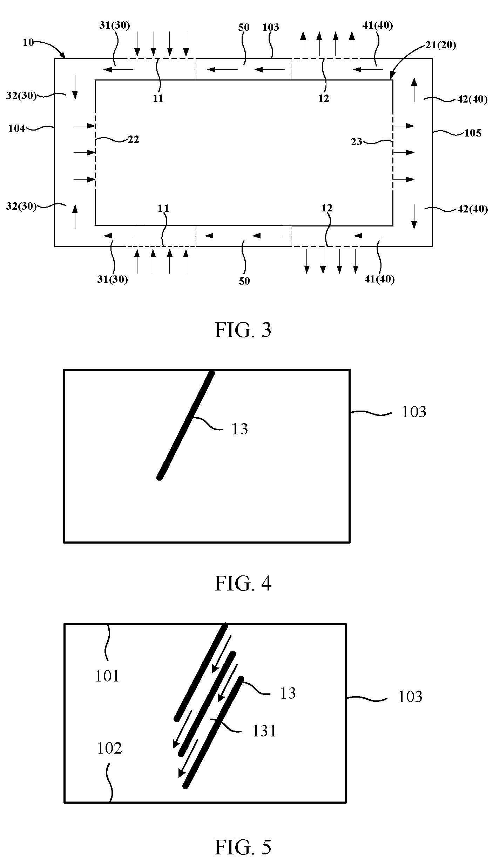

Referring to FIG. 3, in this embodiment of this application, that is according to the claimed invention, an air intake channel 30 may include two parts: a first part 31 formed between an area that is of the first side panel 103 and that is close to the second side panel 104 and a panel of the chassis 21, and a second part 32 formed between the second side panel 104 and the panel of the chassis 21. An air exhaust channel 40 may also include two parts: a third part 41 formed between an area that is of the first side panel 103 and that is close to the third side panel 105 and the panel of the chassis 21, and a fourth part 42 formed between the third side panel 105 and the panel of the chassis 21. An air return channel 50 is also formed between the first side panel 103 and the panel of the chassis 21. The air return channel 50 is located between the first part 31 and the third part 41, and respectively communicates with the first part 31 and the third part 41. In this way, a disposition difficulty of the air return channel 50 can be reduced, and a structure of the electronic device cover 10 can be simplified.

Because hot air rises, a temperature of hot return air close to the top panel 101 in the air return channel 50 is generally higher than a temperature of hot return air close to the bottom panel 102. To avoid a case in which an adjustment effect of the relative humidity of the air inside the chassis is affected because mixed air that is formed after hot return air inside the air return channel 50 enters the air intake channel 30 and mixes with the fresh air encounters temperature imbalance between an upper part and a lower part of the chassis, in this embodiment of this application, referring to FIG. 2 and FIG. 3, that is according to the claimed invention, a baffle plate 13 is disposed on an inner wall of the first side panel 103. The baffle plate 13 is disposed obliquely relative to the bottom panel, and is specifically located between the first air intake window 11 and the first air exhaust window 12. In this case, the air intake channel and the air exhaust channel are respectively located on two sides of the baffle plate, and a gap between the baffle plate and the bottom panel may form a part of the air return channel. The baffle plate 13 is disposed. Therefore, in the air return channel 50, hot return air from a side that is of the baffle plate and that is close to the air exhaust channel 40 mainly enters a side close to the air intake channel 30 through a gap between the baffle plate 13 and the bottom panel 102. In this way, even if hot return air on the side close to the air intake channel 30 still rises, because hot return air is continuously supplied through the gap between the baffle plate 13 and the bottom panel 102 and the hot return air is relatively sufficient in the lower part, after the hot return air enters the air intake channel 30 and mixes with the fresh air, mixed air with a relatively balanced temperature may be obtained.

In this embodiment of this application, that the baffle plate is obliquely relative to the bottom panel includes but is not limited to that the baffle plate is perpendicular to the bottom panel. Specifically, the baffle plate and the bottom panel are not parallel. In this case, the hot return air from a side that is of the baffle plate and that is close to the air exhaust channel 40 mainly enters the side close to the air intake channel 30 through the gap between the baffle plate 13 and the bottom panel 102, so that the hot return air at the bottom is relatively sufficient. Therefore, after the hot return air enters the air intake channel 30 and mixes with the fresh air, the mixed air with the relatively balanced temperature may be obtained.

During specific disposition of the baffle plate 13, the baffle plate 13 may include a first end, a second end, a third end, and a fourth end. The first end and the second end are opposite to each other, the third end is an end that is of the baffle plate 13 and that is close to the top panel 101, and the fourth end is an end that is of the baffle plate 13 and that is close to the bottom panel 102. When the electronic device is disposed inside the electronic device cover 10, the first end may press against the panel of the chassis, the second end is connected to the first side panel, the third end may be connected to the top panel 101 or the third end and the top panel 101 may be disposed at intervals, and the fourth end and the bottom panel 102 are disposed at intervals.

A specific structure form of the baffle plate 13 is not limited. In a specific embodiment of this application, the baffle plate 13 may be specifically of a straight plate structure, and the baffle plate 13 and the top panel 101 may be disposed orthogonally. Alternatively, referring to FIG. 4, the baffle plate 13 may be disposed obliquely facing one side of the air intake channel 30, that is, an included angle between the top panel 101 and a side that is of the baffle plate 13 and that is close to the air intake channel 30 is an acute angle. In this case, the third end of the baffle plate 13 may be connected to the top panel 101, so that the hot return air from a side that is of the baffle plate 13 and that is close to the air exhaust channel 40 can enter the side close to the air intake channel 30 only through the gap between the baffle plate 13 and the bottom panel 102, so that a temperature of the mixed air formed inside the air intake channel 30 is more balanced. In another specific embodiment of this application, the baffle plate 13 may be specifically of a straight plate structure. Alternatively, referring to FIG. 4, the baffle plate 13 may be disposed obliquely facing one side of the air intake channel 30, that is, an included angle between the top panel 101 and the side that is of the baffle plate 13 and that is close to the air intake channel 30 is an acute angle. However, the third end of the baffle plate 13 and the top panel 101 are disposed at intervals, and the fourth end and the bottom panel 102 are disposed at intervals.

Referring to FIG. 2 and FIG. 3, an air guide 14 may be further disposed inside the electronic device cover 10. The air guide 14 may be specifically disposed inside the air return channel 50. The fair guide 14 may guide the hot return air to the air intake channel 30 through the gap between the baffle plate and the bottom panel, to ensure that the hot return air can enter the air intake channel 30 more regularly and efficiently, thereby improving efficiency of forming the mixed air.

A specific structure form of the air guide 14 is not limited. For example, in a specific embodiment of this application, the air guide 14 includes a plurality of guide vanes 141 disposed in parallel. The plurality of guide vanes 141 may be fixed at intervals on an inner wall of the third side panel 105. In this way, a first guide trough 142 may be formed between two adjacent guide vanes 141. During specific implementation, a quantity of first guide trough 142 may be set based on a specific application scenario of the electronic device component. For example, when an ambient temperature in the application scenario is relatively high, there may be a relatively small quantity of guide trough 142; and when the ambient temperature in the application scenario is relatively low, there may be a relatively large quantity of guide trough 142.

With reference to FIG. 3 and FIG. 5, when the fourth end of the baffle plate 13 is disposed obliquely facing one side of the air intake channel 30, there may be a plurality of baffle plates 13. The plurality of baffle plates 13 may be fastened at intervals on an inner wall of the first side panel 103. In addition, in specific disposition, for a baffle plate 13 closest to the top panel 101 in the plurality of baffle plates 13, a third end of the baffle plate 13 may be connected to the top panel 101, and third ends of remaining baffle plates 13 are successively away from the top panel 101. In this way, a second guide trough 131 of the air return channel 50 may be formed between two adjacent baffle plates 13. It can be learned that one end that is of the second guide trough 131 and that communicates with the air exhaust channel 40 is disposed close the top panel 101, and one end that is of the second guide trough 131 and that communicates with the air intake channel 30 is disposed close to the bottom panel 102, so that hot return air from the air exhaust channel 40 can be regularly guided to a lower area that is of the air intake channel 30 and that is close to the bottom panel 102. This helps make the temperature of the mixed air formed inside the air intake channel 30 more balanced. In another implementation, the plurality of baffle plates 13 and the top panel 101 are disposed at intervals, and the third ends of the baffle plates 13 are successively away from the top panel 101. In this way, the second guide trough 131 of the air return channel 50 may be formed between two adjacent baffle plates 13.

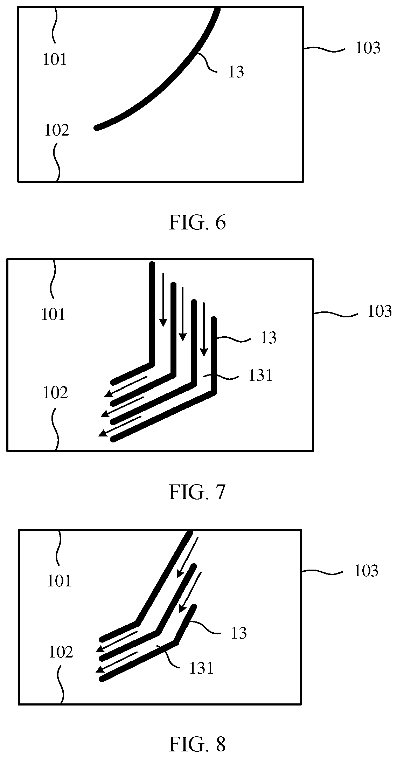

In addition, in some other possible embodiments of this application, the foregoing baffle plate may be further of a bent plate structure. A specific structure form of the bent plate is not limited, for example, may be a combination plate formed by connecting a plurality of straight plates, an arc plate, or a combination plate formed by connecting a straight plate and an arc plate. When the bent plate is used, there may be one or more baffle plates. Referring to FIG. 3 and FIG. 6, when there is one baffle plate 13, the third end of the baffle plate 13 may be connected to the top panel 101, and the fourth end of the baffle plate 13 may bend towards one side of the air intake channel 30. In this case, hot return air from a side that is of the baffle plate 13 and that is close to the air exhaust channel 40 can enter, only through the gap between the baffle plate 13 and the bottom panel 102, the side close to the air intake channel 30, to make the temperature of the mixed air formed inside the air intake channel 30 more balanced. In addition, based on a bending shape of the baffle plate 13, the baffle plate 13 may also have a function of guiding airflow, to guide the hot return air to the lower area that is of the air intake channel 30 and that is close to bottom panel 102. In another possible embodiment, the third end of the baffle plate 13 and the top panel 101 are disposed at intervals, and the fourth end and the bottom panel 102 are disposed at intervals.

When there are a plurality of baffle plates 13, referring to FIG. 7, the plurality of baffle plates 13 may be fastened at intervals on the inner wall of the first side panel 103. In addition, in specific disposition, for a baffle plate 13 closest to the top panel 101 in the plurality of baffles 13, a third end of the baffle plate 13 may be connected to the top panel 101, and third ends of remaining baffle plates 13 are successively away from the top panel 101, so that a second guide trough 131 of the air return channel 50 may be formed between two adjacent baffle plates 13. Similarly, one end that is of the second guide trough 131 and that communicates with the air exhaust channel 40 is disposed close to the top panel 101, and one end that is of the second guide trough 131 and that communicates with the air intake channel 30 is disposed close to the bottom panel 102. In this way, the heat return air from the air exhaust channel 40 can be regularly guided to the lower area that is of the air intake channel 30 and that is close to the bottom panel 102, and this helps make the temperature of the mixed air formed inside the air intake channel 30 more balanced. In another possible embodiment, the third ends of the plurality of baffle plates 13 and the top panel 101 are disposed at intervals, and the third ends of the baffle plates 13 are successively away from the top panel 101.

In the embodiment shown in FIG. 7, the baffle plate 13 of an obtuse angle structure formed by two straight plates is used. In the two straight plates, one straight plate close to the bottom panel 102 is disposed obliquely facing one side of the air intake channel, and one straight plate close to the top panel 101 and the top panel may be disposed orthogonally, or the straight plate close to the top panel 101 may be disposed obliquely facing one side of the air intake channel as shown in FIG. 8. This is not limited in this application. In addition, the straight plate close to the top panel 101 may be connected to the top panel 101, or the top panel 101 and the straight plate close to the top panel 101 may be disposed at intervals.

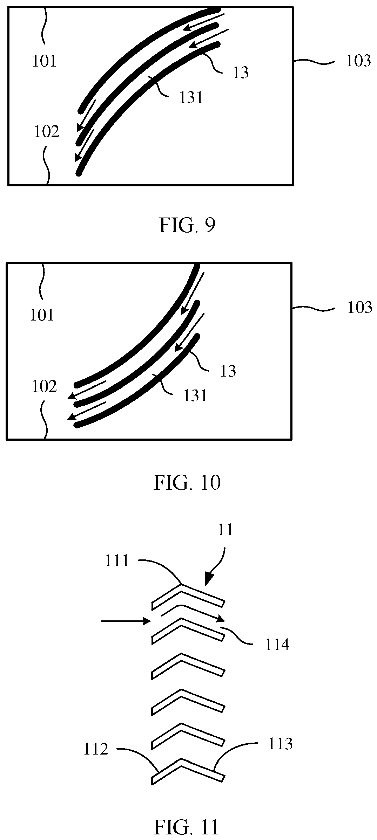

In another embodiment of this application, the baffle plate 13 may alternatively be an arc plate shown in FIG. 9 and FIG. 10. During specific disposition, the baffle plate 13 may protrude towards an air intake channel side as shown in FIG. 9, or may protrude towards an air exhaust channel side as shown in FIG. 10. This is also not limited in this application. Alternatively, there may be one arc plate. The arc plate may be connected to the top panel 101, or the arc plate and the top panel 101 may be disposed at intervals.

It may be understood that, when the first air intake window 11 and the first air exhaust window 12 are respectively disposed on the fourth side panel, a structure symmetrical to that of the first side panel 103 may be used for the fourth side panel, and details are not described herein again.

In the foregoing embodiment, the air return channel 50 is designed, so that the air intake temperature of the air intake vent of the chassis may be increased by about 3°C in combination with an air mixing function and an airflow-guiding function of the baffle plate 13. In this way, the cold air area that is inside the chassis and that is close to the air intake vent can be eliminated, the relative humidity of the air inside the chassis can be reduced to below 60%, and the risk of corrosion of the electronic component such as the board can be reduced.

Referring to FIG. 2, in this embodiment of this application, a second air intake window 15 may be further disposed on a side that is of the top panel 101 and that is close to the second side panel 104, and the second air intake window 15 may communicate with the air intake channel. In this way, external fresh air may enter the air intake channel through both the first air intake window 11 and the second air intake window 15, so that an air intake path may be increased. Similarly, a second air exhaust window 16 may be further disposed on a side that is of the top panel 101 and that is close to the third side panel 105, and the second air exhaust window 16 may communicate with the air exhaust channel. In this way, the hot air inside the air exhaust channel may be discharged through both the first air exhaust window 12 and the second air exhaust window 16, so that an air exhaust path may be increased.

In addition, referring to FIG. 2, a third air intake window 17 may be disposed on the second side panel 104. The third air intake window 17 also communicates with the air intake channel. During disposition, the third air intake window 17 may be specifically a switch window. The electronic device component may be used in different scenarios by adjusting an open state or a closed state of the third air intake window 17. Specifically, when the third air intake window 17 is in the open state, the electronic device component may be used in a scenario with relatively good air quality and relatively sufficient cold air. Opening the third air intake window 17 may increase an air intake path. In this case, a temperature of the fresh air inside the air intake channel is relatively low, and a proportion of the hot return air is relatively small. Even if the fan of the electronic device runs at a low speed, a heat dissipation requirement can be met, and a relatively small noise is generated. In addition, the external air is relatively clean, therefore, less highly corrosive substances enters the chassis and corrosiveness to the electronic component is relatively low. When the third air intake window 17 is in the closed state, the electronic device component may be used in a scenario with relatively poor air quality, for example, in an outdoor environment. In this case, a proportion of the hot return air in the air intake channel relatively increases, so that the air intake temperature of the air intake vent entering the chassis slightly increases, thereby reducing the relative humidity of the air inside the chassis, that is, in this scenario, the risk of corrosion of the electronic component can also be reduced. Therefore, the electronic device cover and the electronic device provided in the embodiments of this application may be used in the outdoor environment.

In the foregoing embodiment, a specific structure form of the third air intake window 17 is not limited. For example, the third air intake window 17 may be a revolving door pivoted on the first side panel through a hinge, or the third air intake window 17 may be a revolving shutter.

To reduce noise impact of the electronic device on an ambient environment, sound-absorbing cotton may be disposed on an inner wall of the electronic device cover 10. In this way, noise generated when the electronic device works can be isolated inside the electronic device cover 10 by using the sound-absorbing cotton. A specific type of the sound-absorbing cotton is not limited. For example, the sound-absorbing cotton may be glass fiber sound-absorbing cotton or polyester fiber sound-absorbing cotton. When the sound-absorbing cotton is disposed on the inner wall of the electronic device cover 10, the sound-absorbing cotton may be specifically bonded and fastened to the inner wall of the electronic device cover 10 through an adhesive, to ensure connection reliability between the sound-absorbing cotton and the inner wall of the electronic device cover 10.

It should be noted that, during disposition, the sound-absorbing cotton is required to be away from positions of the air intake windows and the air exhaust windows on the electronic device cover 10, so as to ensure that the electronic device cover 10 smoothly intakes and exhausts air.

In addition, in this embodiment of this application, the foregoing air intake windows and the air exhaust windows may be shutters. The first air intake window 11 is used as an example. Referring to FIG. 11, a blade 111 of the first air intake window 11 may be specifically a bent blade. The blade 111 includes a first bent portion 112 and a second bent portion 113. The first bent portion 112 is disposed close to the inside of the electronic device cover relative to the second bent portion 113, and an included angle between the first bent portion 112 and the second bent portion 113 is less than 180 degrees. In this design, an air intake hole 114 formed between two adjacent blades 111 is a bent hole. When a sound in the electronic device cover spreads out through the air intake hole 114, a plurality of reflections or refractions occurs. During the plurality of reflections and refractions, a part of sound energy is absorbed by air. In this way, the sound that finally spreads out the electronic device cover can be weakened, thereby further reducing noise. Experiments show that noise can be reduced by about 3 decibels through the shutters in combination with the sound-absorbing cotton on the inner wall of the electronic device cover, so that the electronic device meets a noise standard of 55 decibels in office scenarios.

In some other embodiments, the air intake windows and the air exhaust windows may further use a maze-type shutter to implement noise reduction. A structure of the maze-type shutter may be similar to that in the conventional technology. Details are not described in this application.

In addition, the electronic device component may be further vertically installed in a non-cabinet scenario such as an office by disposing the electronic device cover, to improve a high-quality industrial design of an appearance of the electronic device component.

In conclusion, according to the electronic device cover provided in the embodiments of this application, the air return channel is disposed to return a part of hot air to the air intake channel, so that the air intake temperature of the chassis can be slightly increased without affecting heat dissipation performance of the electronic device. In this way, the cold air area that is inside the chassis and that is close to the air intake vent may be eliminated, the relative humidity of the air inside the chassis may be reduced, and the risk of corrosion of the electronic component such as the board may be reduced.

Referring to FIG. 1, an embodiment of this application further provides an electronic device component. The electronic device component includes an electronic device 20 and the electronic device cover 10 in any one of the foregoing possible embodiments. The electronic device 20 may be a server, a communications device, a network device, a storage device, a router, a switch, or the like in the conventional technology. The electronic device may be disposed inside the electronic device cover 10. The electronic device cover 10 may reduce relative humidity inside the electronic device 20 by adjusting an air intake temperature of the electronic device, so that a risk of corrosion on an electronic component inside the electronic device 20 can be reduced, and corrosion resistance performance of the electronic device can be improved.

The foregoing descriptions are merely specific implementations of this application, but are not intended to limit the protection scope of this application. Therefore, the protection scope of this application is defined by the appended claims.

## Claims

1. An electronic device component, comprising an electronic device and an electronic device cover (10), , wherein the electronic device is disposed inside the electronic device cover;
a first air intake window (11) and a first air exhaust window (12) are disposed on the electronic device cover, the first air intake window (11) is configured to communicate with an air intake vent (22) of the electronic device to form an air intake channel (30), and the first air exhaust window (12) is configured to communicate with an air exhaust vent (23) of the electronic device to form an air exhaust channel (40); and
an air return channel (50) is disposed inside the electronic device cover, and the air return channel (50) is configured to communicate the air exhaust channel (40) and the air intake channel (30);
the electronic device comprises a chassis (21), and components such as a board and a fan disposed inside the chassis, wherein an air intake side of the fan is disposed facing the air intake vent (22) and an air exhaust side of the fan is disposed facing the air exhaust vent (23), and the air intake vent (22) and the air exhaust vent (23) are respectively disposed on two panels on two opposite sides of the chassis (21);
wherein the electronic device cover further comprises a top panel (101), a first side panel (103), a second side panel (104), a third side panel (105), a fourth side panel, and a bottom panel (102), the first side panel (103) is connected to the top panel (101) and the bottom panel (102), the top panel (101) and the bottom panel (102) are opposite to each other, the first side panel (103) and the fourth side panel are opposite to each other, the second side panel (104) and the third side panel (105) are opposite to each other, and the second side panel (104) and the third side panel (105) are respectively connected to two sides of the first side panel (103);
the second side panel (104) is disposed opposite to a panel of a side that is of the chassis (21) and on which the air intake vent (22) is disposed, and third side panel (105) is disposed opposite to a panel on a side that is on the chassis (21) and on which the air exhaust vent (23) is disposed;
wherein the first air intake window (11) and the first air exhaust window (12) are disposed on the first side panel (103);
the air intake channel (30) comprises a first part (31) formed between an area that is of the first side panel (103) and that is close to the second side panel (104) and a panel of the chassis (21), and a second part (32) formed between the second side panel (104) and the panel of the chassis (21);
the air exhaust channel (40) comprises a third part (41) formed between an area that is of the first side panel (103) and that is close to the third side panel (105) and the panel of the chassis (21), and a fourth part (42) formed between the third side panel (105) and the panel of the chassis (21);
the air return channel (50) is formed between the first side panel (103) and the panel of the chassis (21), and the air return channel (50) is located between the first part (31) and the third part (41), and respectively communicates with the first part (31) and the third part (41); and
a baffle plate (13) is disposed on an inner wall of the first side panel (103), and the baffle plate (13) is disposed obliquely relative to the bottom panel (102), and is located between the first air intake window (11) and the first air exhaust window (12); and
the air intake channel (30) and the air exhaust channel (40) are respectively located on two sides of the baffle plate (13), and a gap between the baffle plate (13) and the bottom panel (102) forms a part of the air return channel (50).

2. The electronic device component according to claim 1, wherein the baffle plate is located between the first air intake window and the first air exhaust window.

3. The electronic device component according to any one of claims 1 to 2, wherein a first end of the baffle plate is configured to press against the electronic device, a second end of the baffle plate is connected to the first side panel, a third end of the baffle plate is connected to the top panel or a third end of the baffle plate and the top panel are disposed at intervals, and a fourth end of the baffle plate and the bottom panel are disposed at intervals, wherein
the first end and the second end are opposite to each other, the third end is an end that is of the baffle plate and that is close to the top panel, and the fourth end is an end that is of the baffle plate and that is close to the bottom panel.

4. The electronic device component according to claim 3, wherein the baffle plate is of a straight plate structure, and the baffle plate and the top panel are disposed orthogonally; or an included angle between a side that is of the baffle plate and that is close to the air intake channel and the top panel is an acute angle.

5. The electronic device component according to claim 4, wherein the third end is connected to the top panel; and
an air guide is disposed inside the electronic device cover, and the air guide is disposed inside the air return channel, and is configured to guide a part of return air from the air exhaust channel to the air intake channel through the gap between the baffle plate and the bottom panel.

6. The electronic device component according to claim 5, wherein the air guide comprises a plurality of guide vanes, the plurality of guide vanes are disposed at intervals on the inner wall of the first side panel, and two adjacent guide vanes form a first guide trough.

7. The electronic device component according to claim 4, wherein when the included angle between the side that is of the baffle plate and that is close to the air intake channel and the top panel is an acute angle,
there are a plurality of baffle plates, the plurality of baffle plates are disposed at intervals on the inner wall of the first side panel, third ends of the plurality of baffle plates are successively far away from the top panel, two adjacent baffle plates form a second guide trough of the air return channel, and one end that is of the second guide trough and that communicates with the air intake channel is disposed close to the bottom panel.

8. The electronic device component according to claim 3, wherein the baffle plate is of a bent plate structure, and there are one or more baffle plates.

9. The electronic device component according to claim 8, wherein there are a plurality of baffle plates, the plurality of baffle plates are disposed at intervals on the inner wall of the first side panel, third ends of the plurality of baffle plates are successively far away from the top panel, two adjacent baffle plates form a second guide trough of the air return channel, and one end that is of the second guide trough and that communicates with the air intake channel is disposed close to the bottom panel.

10. The electronic device component according to claim 1, wherein the first air intake window and the first air exhaust window are shutters, blades of the shutters each comprise a first bent portion and a second bent portion, the first bent portion is disposed close to the inside of the electronic device cover, and an included angle between the first bent portion and the second bent portion is less than 180 degrees.

11. The electronic device component according to any of claims 1 to 10, wherein a second air intake window is disposed on a side that is of the top panel and that is close to the second side panel, and the second air intake window communicates with the air intake channel; and
a second air exhaust window is disposed on a side that is of the top panel and that is close to the third side panel, and the second air exhaust window communicates with the air exhaust channel.

12. The electronic device component according to any of claims 1 to 11, wherein a third air intake window is disposed on the second side panel, the third air intake window communicates with the air intake channel, and the third air intake window is a window capable of opening and closing.

13. The electronic device component according to any one of claims 1 to 12, wherein the electronic device cover may be used in an outdoor environment.

14. The electronic device component according to any of claims 1 to 13, wherein the electronic device is a server, a network device or a storage device.

## Patentansprüche

1. Elektronische Vorrichtungskomponente, umfassend eine elektronische Vorrichtung und eine Abdeckung (10) der elektronischen Vorrichtung, wobei die elektronische Vorrichtung im Inneren der Abdeckung der elektronischen Vorrichtung angeordnet ist;
ein erstes Lufteinlassfenster (11) und ein erstes Luftauslassfenster (12) an der Abdeckung der elektronischen Vorrichtung angeordnet sind, das erste Lufteinlassfenster (11) dazu ausgelegt ist, mit einer Lufteinlassöffnung (22) der elektronischen Vorrichtung in Verbindung zu stehen, um einen Lufteinlasskanal (30) zu bilden, und das erste Luftauslassfenster (12) dazu ausgelegt ist, mit einer Luftauslassöffnung (23) der elektronischen Vorrichtung in Verbindung zu stehen, um einen Luftauslasskanal (40) zu bilden; und
ein Luftrückführkanal (50) innerhalb der Abdeckung der elektronischen Vorrichtung angeordnet ist und der Luftrückführkanal (50) dazu ausgelegt ist, den Luftauslasskanal (40) mit dem Lufteinlasskanal (30) zu verbinden;
die elektronische Vorrichtung ein Chassis (21) und innerhalb des Chassis angeordnete Komponenten wie etwa eine Platine und einen Lüfter umfasst, wobei eine Lufteinlassseite des Lüfters der Lufteinlassöffnung (22) zugewandt angeordnet ist, eine Luftauslassseite des Lüfters der Luftauslassöffnung (23) zugewandt angeordnet ist und die Lufteinlassöffnung (22) und die Luftauslassöffnung (23) jeweils an einer von zwei Platten an zwei einander gegenüberliegenden Seiten des Chassis (21) angeordnet sind;
wobei die Abdeckung der elektronischen Vorrichtung ferner eine obere Platte (101), eine erste Seitenplatte (103), eine zweite Seitenplatte (104), eine dritte Seitenplatte (105), eine vierte Seitenplatte und eine untere Platte (102) umfasst, die erste Seitenplatte (103) mit der oberen Platte (101) und der unteren Platte (102) verbunden ist, die obere Platte (101) und die untere Platte (102) einander gegenüberliegen, die erste Seitenplatte (103) und die vierte Seitenplatte einander gegenüberliegen, die zweite Seitenplatte (104) und die dritte Seitenplatte (105) einander gegenüberliegen und die zweite Seitenplatte (104) und die dritte Seitenplatte (105) jeweils mit einer von zwei Seiten der ersten Seitenplatte (103) verbunden sind;
die zweite Seitenplatte (104) gegenüber einer Platte an derjenigen Seite des Chassis (21) angeordnet ist, an der die Lufteinlassöffnung (22) angeordnet ist, und die dritte Seitenplatte (105) gegenüber einer Platte an derjenigen Seite des Chassis (21) angeordnet ist, an der die Luftauslassöffnung (23) angeordnet ist;
wobei das erste Lufteinlassfenster (11) und das erste Luftauslassfenster (12) an der ersten Seitenplatte (103) angeordnet sind;
der Lufteinlasskanal (30) einen ersten Teil (31), der zwischen einem nahe der zweiten Seitenplatte (104) liegenden Bereich der ersten Seitenplatte (103) und einer Platte des Chassis (21) gebildet ist, und einen zweiten Teil (32), der zwischen der zweiten Seitenplatte (104) und der Platte des Chassis (21) gebildet ist, umfasst;
der Luftauslasskanal (40) einen dritten Teil (41), der zwischen einem nahe der dritten Seitenplatte (105) liegenden Bereich der ersten Seitenplatte (103) und der Platte des Chassis (21) gebildet ist, und einen vierten Teil (42), der zwischen der dritten Seitenplatte (105) und der Platte des Chassis (21) gebildet ist, umfasst;
der Luftrückführkanal (50) zwischen der ersten Seitenplatte (103) und der Platte des Chassis (21) gebildet ist und der Luftrückführkanal (50) zwischen dem ersten Teil (31) und dem dritten Teil (41) angeordnet ist und jeweils mit dem ersten Teil (31) und dem dritten Teil (41) in Verbindung steht; und
eine Prallplatte (13) an einer Innenwand der ersten Seitenplatte (103) angeordnet ist, die Prallplatte (13) relativ zur unteren Platte (102) schräg angeordnet ist und sich zwischen dem ersten Lufteinlassfenster (11) und dem ersten Luftauslassfenster (12) befindet; und
der Lufteinlasskanal (30) und der Luftauslasskanal (40) jeweils auf einer von zwei Seiten der Prallplatte (13) angeordnet sind und ein Spalt zwischen der Prallplatte (13) und der unteren Platte (102) einen Teil des Luftrückführkanals (50) bildet.

2. Elektronische Vorrichtungskomponente nach Anspruch 1, wobei sich die Prallplatte zwischen dem ersten Lufteinlassfenster und dem ersten Luftauslassfenster befindet.

3. Elektronische Vorrichtungskomponente nach einem der Ansprüche 1 bis 2, wobei ein erstes Ende der Prallplatte dazu ausgelegt ist, gegen die elektronische Vorrichtung zu drücken, ein zweites Ende der Prallplatte mit der ersten Seitenplatte verbunden ist, ein drittes Ende der Prallplatte mit der oberen Platte verbunden ist oder ein drittes Ende der Prallplatte und die obere Platte voneinander beabstandet angeordnet sind, und ein viertes Ende der Prallplatte und die untere Platte voneinander beabstandet angeordnet sind, wobei
das erste Ende und das zweite Ende einander gegenüberliegen, das dritte Ende ein nahe der oberen Platte liegendes Ende der Prallplatte ist und das vierte Ende ein nahe der unteren Platte liegendes Ende der Prallplatte ist.

4. Elektronische Vorrichtungskomponente nach Anspruch 3, wobei die Prallplatte eine gerade Plattenstruktur aufweist und die Prallplatte und die obere Platte orthogonal zueinander angeordnet sind; oder der zwischen einer nahe dem Lufteinlasskanal liegenden Seite der Prallplatte und der oberen Platte eingeschlossene Winkel ein spitzer Winkel ist.

5. Elektronische Vorrichtungskomponente nach Anspruch 4, wobei das dritte Ende mit der oberen Platte verbunden ist; und
eine Luftführung innerhalb der Abdeckung der elektronischen Vorrichtung angeordnet ist, wobei die Luftführung innerhalb des Luftrückführkanals angeordnet und dazu ausgelegt ist, einen Teil der Rückluft aus dem Luftauslasskanal durch den Spalt zwischen der Prallplatte und der unteren Platte zum Lufteinlasskanal zu leiten.

6. Elektronische Vorrichtungskomponente nach Anspruch 5, wobei die Luftführung eine Mehrzahl von Leitschaufeln umfasst, die Leitschaufeln voneinander beabstandet an der Innenwand der ersten Seitenplatte angeordnet sind und zwei benachbarte Leitschaufeln eine erste Führungsrinne bilden.

7. Elektronische Vorrichtungskomponente nach Anspruch 4, wobei, wenn der zwischen einer nahe dem Lufteinlasskanal liegenden Seite der Prallplatte und der oberen Platte eingeschlossene Winkel ein spitzer Winkel ist,
eine Mehrzahl von Prallplatten vorhanden ist, die Mehrzahl von Prallplatten voneinander beabstandet an der Innenwand der ersten Seitenplatte angeordnet sind, die dritten Enden der Prallplatten aufeinanderfolgend weiter von der oberen Platte entfernt sind, zwei benachbarte Prallplatten eine zweite Führungsrinne des Luftrückführkanals bilden und ein Ende der zweiten Führungsrinne, das mit dem Lufteinlasskanal in Verbindung steht, nahe der unteren Platte angeordnet ist.

8. Elektronische Vorrichtungskomponente nach Anspruch 3, wobei die Prallplatte eine gebogene Plattenstruktur aufweist und eine oder mehrere Prallplatten vorhanden sind.

9. Elektronische Vorrichtungskomponente nach Anspruch 8, wobei eine Mehrzahl von Prallplatten vorhanden ist, die Prallplatten voneinander beabstandet an der Innenwand der ersten Seitenplatte angeordnet sind, die dritten Enden der Prallplatten aufeinanderfolgend weiter von der oberen Platte entfernt sind, zwei benachbarte Prallplatten eine zweite Führungsrinne des Luftrückführkanals bilden und ein Ende der zweiten Führungsrinne, das mit dem Lufteinlasskanal in Verbindung steht, nahe der unteren Platte angeordnet ist.

10. Elektronische Vorrichtungskomponente nach Anspruch 1, wobei das erste Lufteinlassfenster und das erste Luftauslassfenster Jalousien sind, die Lamellen der Jalousien jeweils einen ersten gebogenen Abschnitt und einen zweiten gebogenen Abschnitt umfassen, der erste gebogene Abschnitt nahe der Innenseite der Abdeckung der elektronischen Vorrichtung angeordnet ist und der zwischen dem ersten gebogenen Abschnitt und dem zweiten gebogenen Abschnitt eingeschlossene Winkel kleiner als 180 Grad ist.

11. Elektronische Vorrichtungskomponente nach einem der Ansprüche 1 bis 10, wobei ein zweites Lufteinlassfenster an einer nahe der zweiten Seitenplatte liegenden Seite der oberen Platte angeordnet ist und das zweite Lufteinlassfenster mit dem Lufteinlasskanal in Verbindung steht; und
ein zweites Luftauslassfenster an einer nahe der dritten Seitenplatte liegenden Seite der oberen Platte angeordnet ist und das zweite Luftauslassfenster mit dem Luftauslasskanal in Verbindung steht.

12. Elektronische Vorrichtungskomponente nach einem der Ansprüche 1 bis 11, wobei ein drittes Lufteinlassfenster an der zweiten Seitenplatte angeordnet ist, das dritte Lufteinlassfenster mit dem Lufteinlasskanal in Verbindung steht und das dritte Lufteinlassfenster ein Fenster ist, das geöffnet und geschlossen werden kann.

13. Elektronische Vorrichtungskomponente nach einem der Ansprüche 1 bis 12, wobei die Abdeckung der elektronischen Vorrichtung in einer Außenumgebung verwendet werden kann.

14. Elektronische Vorrichtungskomponente nach einem der Ansprüche 1 bis 13, wobei die elektronische Vorrichtung ein Server, eine Netzwerkvorrichtung oder eine Speichervorrichtung ist.

## Revendications

1. Composant de dispositif électronique comprenant un dispositif électronique et une enveloppe de dispositif électronique (10), dans lequel le dispositif électronique est disposé à l'intérieur de l'enveloppe de dispositif électronique ;
une première fenêtre d'admission d'air (11) et une première fenêtre d'évacuation d'air (12) sont disposées sur l'enveloppe de dispositif électronique, la première fenêtre d'admission d'air (11) est configurée pour communiquer avec une ventilation d'admission d'air (22) du dispositif électronique pour former un canal d'admission d'air (30), et la première fenêtre d'évacuation d'air (12) est configurée pour communiquer avec une ventilation d'évacuation d'air (23) du dispositif électronique pour former un canal d'évacuation d'air (40) ; et
un canal de retour d'air (50) est disposé à l'intérieur de l'enveloppe de dispositif électronique, et le canal de retour d'air (50) est configuré pour faire communiquer le canal d'évacuation d'air (40) et le canal d'admission d'air (30) ;
le dispositif électronique comprend un châssis (21), et des composants tels qu'une carte et un ventilateur disposés à l'intérieur du châssis, un côté d'admission d'air du ventilateur faisant face à la ventilation d'admission d'air (22) et un côté d'évacuation d'air du ventilateur faisant face à la ventilation d'évacuation d'air (23), et la ventilation d'admission d'air (22) et la ventilation d'évacuation d'air (23) étant respectivement disposées sur deux panneaux sur deux côtés opposés du châssis (21) ;
dans lequel l'enveloppe de dispositif électronique comprend en outre un panneau supérieur (101), un premier panneau latéral (103), un deuxième panneau latéral (104), un troisième panneau latéral (105), un quatrième panneau latéral, et un panneau inférieur (102), le premier panneau latéral (103) est relié au panneau supérieur (101) et au panneau inférieur (102), le panneau supérieur (101) et le panneau inférieur (102) sont opposés l'un à l'autre, le premier panneau latéral (103) et le quatrième panneau latéral sont opposés l'un à l'autre, le deuxième panneau latéral (104) et le troisième panneau latéral (105) sont opposés l'un à l'autre, et le deuxième panneau latéral (104) et le troisième panneau latéral (105) sont reliés respectivement à deux côtés du premier panneau latéral (103) ;
le deuxième panneau latéral (104) est disposé à l'opposé d'un panneau d'un côté du châssis (21) et sur lequel est disposé la ventilation d'admission d'air (22), et un troisième panneau latéral (105) est disposé à l'opposé d'un panneau sur un côté sur le châssis (21) et sur lequel est disposée la ventilation d'évacuation d'air (23) ;
dans lequel la première fenêtre d'admission d'air (11) et la première fenêtre d'évacuation d'air (12) sont disposées sur le premier panneau latéral (103) ;
le canal d'admission d'air (30) comporte une première partie (31) formée entre une zone du premier panneau de côté (103) et proche du deuxième panneau de côté (104) et un panneau du châssis (21), et une deuxième partie (32) formée entre le deuxième panneau de côté (104) et le panneau du châssis (21) ;
le canal d'évacuation d'air (40) comporte une troisième partie (41) formée entre une zone du premier panneau latéral (103) et proche du troisième panneau latéral (105) et du panneau du châssis (21), et une quatrième partie (42) formée entre le troisième panneau latéral (105) et le panneau du châssis (21) ;
le canal de retour d'air (50) est formé entre le premier panneau latéral (103) et le panneau du châssis (21), et le canal de retour d'air (50) est situé entre la première partie (31) et la troisième partie (41), et communique respectivement avec la première partie (31) et la troisième partie (41) ; et
une plaque déflectrice (13) est disposée sur une paroi interne du premier panneau latéral (103), et la plaque déflectrice (13) est disposée obliquement par rapport au panneau inférieur (102), et est située entre la première fenêtre d'admission d'air (11) et la première fenêtre d'évacuation d'air (12) ; et
le canal d'admission d'air (30) et le canal d'évacuation d'air (40) sont situés respectivement sur deux côtés de la plaque déflectrice (13), et un espace entre la plaque déflectrice (13) et le panneau inférieur (102) fait partie du canal de retour d'air (50).

2. Composant de dispositif électronique selon la revendication 1, dans lequel la plaque déflectrice est située entre la première fenêtre d'admission d'air et la première fenêtre d'évacuation d'air.

3. Composant de dispositif électronique selon l'une quelconque des revendications 1 à 2, dans lequel une première extrémité de la plaque déflectrice est configurée pour presser contre le dispositif électronique, une deuxième extrémité de la plaque déflectrice est reliée au premier panneau latéral, une troisième extrémité de la plaque déflectrice est reliée au panneau supérieur ou une troisième extrémité de la plaque déflectrice et le panneau supérieur sont disposés à intervalles, et une quatrième extrémité de la plaque déflectrice et le panneau inférieur sont disposés à intervalles, dans lequel
la première extrémité et la deuxième extrémité sont opposées l'une à l'autre, la troisième extrémité est une extrémité de la plaque déflectrice et proche du panneau supérieur, et la quatrième extrémité est une extrémité de la plaque déflectrice et proche du panneau inférieur.

4. Composant de dispositif électronique selon la revendication 3, dans lequel la plaque déflectrice est d'une structure de plaque droite, et la plaque déflectrice et le panneau supérieur sont disposés orthogonalement ; ou un angle inclus entre un côté de la plaque déflectrice et proche du canal d'admission d'air et le panneau supérieur est un angle aigu.

5. Composant de dispositif électronique selon la revendication 4, dans lequel la troisième extrémité est reliée au panneau supérieur ; et
un guide d'air est disposé à l'intérieur de l'enveloppe de dispositif électronique, et le guide d'air est disposé à l'intérieur du canal de retour d'air, et est configuré pour guider une partie de l'air de retour du canal d'évacuation d'air vers le canal d'admission d'air à travers l'espace entre la plaque déflectrice et le panneau inférieur.

6. Composant de dispositif électronique selon la revendication 5, dans lequel le guide d'air comprend une pluralité d'aubes de guidage, la pluralité d'aubes de guidage sont disposées à des intervalles sur la paroi intérieure du premier panneau latéral, et deux aubes de guidage adjacentes forment une première gouttière de guidage.

7. Composant de dispositif électronique selon la revendication 4, dans lequel, lorsque l'angle inclus entre le côté de la plaque déflectrice et proche du canal d'admission d'air et le panneau supérieur est un angle aigu,
il y a une pluralité de plaques déflectrices, la pluralité de plaques déflectrices sont disposées à intervalles sur la paroi intérieure du premier panneau latéral, les troisièmes extrémités de la pluralité de plaques déflectrices sont successivement éloignées du panneau supérieur, deux plaques déflectrices adjacentes forment une deuxième gouttière de guidage du canal de retour d'air, et une extrémité de la deuxième gouttière de guidage communique avec le canal d'admission d'air est disposée à proximité du panneau inférieur.

8. Composant de dispositif électronique selon la revendication 3, dans lequel la plaque déflectrice est d'une structure de plaque courbée, et il y a une ou plusieurs plaques déflectrices.

9. Composant de dispositif électronique selon la revendication 8, dans lequel il y a une pluralité de plaques déflectrices, la pluralité de plaques déflectrices sont disposées à intervalles sur la paroi intérieure du premier panneau latéral, les troisièmes extrémités de la pluralité de plaques déflectrices sont successivement éloignées du panneau supérieur, deux plaques déflectrices adjacentes forment une deuxième gouttière de guidage du canal de retour d'air, et une extrémité de la deuxième gouttière de guidage qui communique avec le canal d'admission d'air est disposée à proximité du panneau inférieur.

10. Composant de dispositif électronique selon la revendication 1, dans lequel la première fenêtre d'admission d'air et la première fenêtre d'évacuation d'air sont des obturateurs, les lames des obturateurs comprennent chacune une première partie courbée et une deuxième partie courbée, la première partie courbée est disposée proche de l'intérieur de l'enveloppe de dispositif électronique, et un angle inclus entre la première partie courbée et la deuxième partie courbée est inférieur à 180 degrés.

11. Composant de dispositif électronique selon l'une quelconque des revendications 1 à 10, dans lequel une deuxième fenêtre d'admission d'air est disposée sur un côté du panneau supérieur et proche du deuxième panneau latéral, et la deuxième fenêtre d'admission d'air communique avec le canal d'admission d'air ; et
une deuxième fenêtre d'évacuation d'air est disposée sur un côté du panneau supérieur et proche du troisième panneau latéral, et la deuxième fenêtre d'évacuation d'air communique avec le canal d'évacuation d'air.

12. Composant de dispositif électronique selon l'une quelconque des revendications 1 à 11, dans lequel une troisième fenêtre d'admission d'air est disposée sur le deuxième panneau latéral, la troisième fenêtre d'admission d'air communique avec le canal d'admission d'air, et la troisième fenêtre d'admission d'air est une fenêtre capable de s'ouvrir et de se fermer.

13. Composant de dispositif électronique selon l'une quelconque des revendications 1 à 12, dans lequel l'enveloppe de dispositif électronique peut être utilisée dans un environnement extérieur.

14. Composant de dispositif électronique selon l'une quelconque des revendications 1 à 13, dans lequel le dispositif électronique est un serveur, un dispositif de réseau ou un dispositif de stockage.
